# EUROPEAN PATENT APPLICATION

(11) **EP 4 664 165 A1**
(43) Date of publication of application: **17.12.2025**
(21) Application number: 24305917.7
(22) Date of filing: 11.06.2024
(51) Int. Cl.: G02B 6/00, H01L 23/00, H01S 5/0239, H01S 5/02, H01S 5/22, H01S 5/343, H01S 5/40, G02B 6/12, H01S 5/227

(54) **SEMICONDUCTOR DEVICE AND SEMICONDUCTOR DEVICE FABRICATION METHOD**

(71) Applicant: Nokia Solutions and Networks Oy, 02610 Espoo (FI)
(72) Inventor: BESANCON, Claire, 75014 Paris (FR); DECOBERT, Jean, 91620 Nozay (FR)
(74) Representative: Novagraaf Technologies

(57) **Abstract**

A semiconductor device (100) is provided. The semiconductor device comprises a silicon substrate (102) having a silica layer (104) thereon. One or more laser structures (106) are on the silica layer. The one or more laser structures comprise layered III-V materials. A photodiode 128 is on the silica layer. The photodiode comprises layered III-V materials. The photodiode is laterally and/or longitudinally displaced along the silica layer from a closest laser structure of the one or more laser structures by a maximum distance d, wherein d is less than 100 micrometers. A semiconductor device fabrication method is also provided.

## Description

### Field

Examples of the present disclosure relates to semiconductor devices and semiconductor device fabrication methods.

### Background

Silicon-on-insulator (SOI) technology is important to silicon photonics. However, there are challenges in integrating III-V materials into such technology in order to exploit the beneficial characteristics of both SOI and III-V materials.

An objective of the present disclosure is to address such challenges, amongst others.

### Summary

In a first exemplary aspect, there is provided semiconductor device comprising:
a silicon substrate having a silica layer thereon;
one or more laser structures on the silica layer, wherein the one or more laser structures comprise layered III-V materials; and
a photodiode on the silica layer, wherein the photodiode comprises layered III-V materials;
wherein the photodiode is laterally and/or longitudinally displaced along the silica layer from a closest laser structure of the one or more laser structures by a maximum distance d, wherein d is less than 100 micrometers.

Optionally, the distance d is less than 10 micrometers.

Optionally, the layered III-V materials of the one or more laser structures comprise:
an n-type doped InP layer on the silica layer;
a quantum well layer on the n-type doped InP layer;
a p-type doped InP layer on the quantum well layer; and
a p-type doped InGaAs layer on the p-type doped InP layer.

Optionally, the one or more laser structures further comprise:
a semi-insulating InP layer arranged on the n-type doped InP layer and extending at least partially along and at least partially surrounding the quantum well layer, the p-type doped InP layer and the p-type doped InGaAs layer.

Optionally, the photodiode is an InGaAs-based photodiode.

Optionally, the layered III-V materials of the photodiode comprise:
an n-type doped InP layer on the silica layer;
a p-type doped InGaAs layer on the n-type doped InP layer; and
a p-type doped InP layer on the p-type doped InGaAs layer.

Optionally, one or more photonic components are comprised within the silica layer.

Optionally, the one or more photonic components comprise a PN junction modulator.

Optionally, the photodiode and one or more laser structures are buried in an encasing layer arranged on the silica layer.

Optionally, the semiconductor device further comprises first through-holes in the encasing layer, the first through-holes connecting a surface of the encasing layer away from the silica layer to bottom layers of the photodiode and one or more laser structures, the bottom layers being layers of the III-V materials abutting the silica layer; and
second through-holes in the encasing layer, the second through-holes connecting the surface of the encasing layer to top layers of the photodiode and one or more laser structures, the top layers being layers of the III-V materials away from the silica layer;
wherein metallization layers are arranged in the first through-holes and the second through-holes as electric contacts of the photodiode and one or more laser structures.

Optionally, the one or more laser structures are a plurality of laser structures configured as a coarse wavelength division multiplexer.

In a second exemplary aspect, there is provided a semiconductor device fabrication method, the method comprising:
providing a first silicon substrate having a first silica layer thereon, wherein one or more devices are arranged on the first silica layer, the one or more devices comprising layered III-V materials;
selectively etching the first silica layer to at least partially disconnect the one or more devices from the first silicon substrate;
removing the one or more devices from the first silicon substrate using a micro-transfer printing stamp;
providing a second silicon substate having a second silica layer thereon, wherein one or more photonic components are arranged in the second silica layer;
depositing the one or more devices onto the second silica layer of the second silicon substrate, from the micro-transfer printing stamp.

Optionally, the one or more devices are a laser structure or a photodiode;
wherein the layered III-V materials of the laser structure comprise:
   an n-type doped InP layer on the silica layer;
   a quantum well layer on the n-type doped InP layer;
   a p-type doped InP layer on the quantum well layer; and
   a p-type doped InGaAs layer on the p-type doped InP layer;
and wherein the layered III-V materials of the photodiode comprise:
   an n-type doped InP layer on the silica layer;
   a p-type doped InGaAs layer on the n-type doped InP layer; and a p-type doped InP layer on the p-type doped InGaAs layer.

Optionally, the method further comprises:
at least partially encapsulating the one or more devices with a resist layer before selectively etching the first silica layer to at least partially disconnect the one or more devices from the first silicon substrate.

Optionally, the one or more devices are one or more first devices, and the method further comprises:
providing a third silicon substrate having a third silica layer thereon, wherein one or more second devices are arranged on the third silica layer, the one or more second devices comprising layered III-V materials that are a different type of device to the one or more first devices;
selectively etching the third silica layer to at least partially disconnect the one or more second devices from the third silicon substrate;
removing the one or more second devices from the third silicon substrate using a second micro-transfer printing stamp;
depositing the one or more second devices onto the second silica layer of the second silicon substrate, from the second micro-transfer printing stamp.

Optionally, the one or more first devices and the one or more second devices are arranged as one or more CWDM systems, each CWDM system having the second device that is a photodiode and a plurality of the first devices that are laser structures arranged as a laser array;
wherein for a CWDM system, the photodiode is laterally and/or longitudinally displaced along the second silica layer from a closest laser structure of the laser array by a maximum distance d, wherein d is less than 100 micrometers.

### Brief Description of Drawings

Examples of the disclosure are now described, with reference to the drawings, in which:
FIGS. 1A and 1B are a cross-sectional views of a schematic diagram of a semiconductor device;
FIG. 1C is a top-down view of a schematic diagram of a semiconductor device;
FIGS. 2A to 2J show an exemplary method for fabricating the semiconductor device of FIGS. 1A to 1C;
FIGS. 3A to 3F show an exemplary method of fabricating a first silicon substrate having a first silica layer thereon, and layered III-V materials of laser structure(s) on the first silica layer, of FIG. 2A;
FIG. 4 is a schematic cross-sectional diagram of a photodiode structure; and
FIG. 5 is a flow chart of a semiconductor device fabrication method that corresponds to the semiconductor device fabrication methods described with reference to FIGS. 2A to 2J.

### Detailed Description

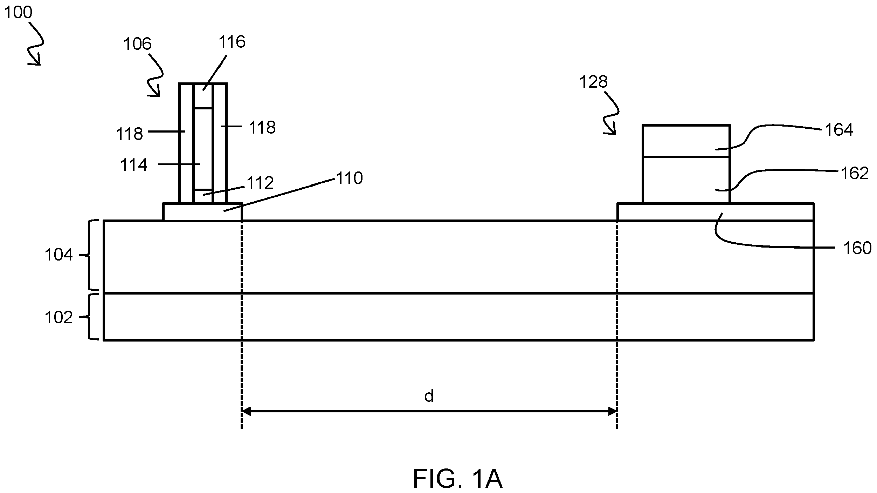

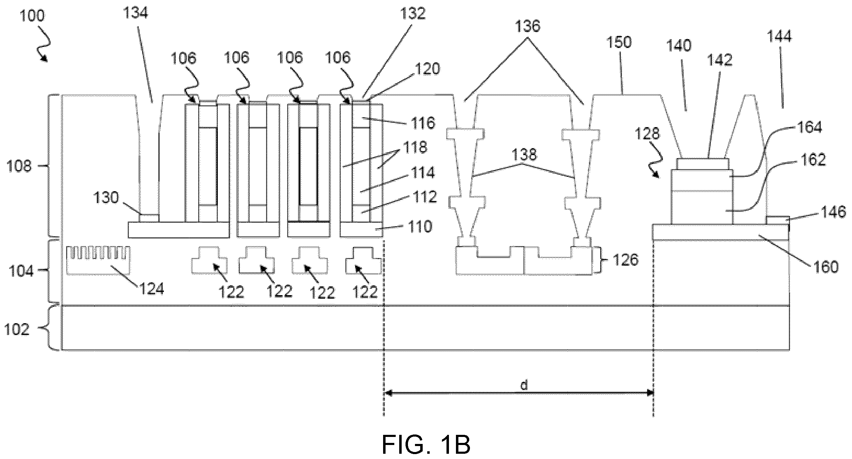

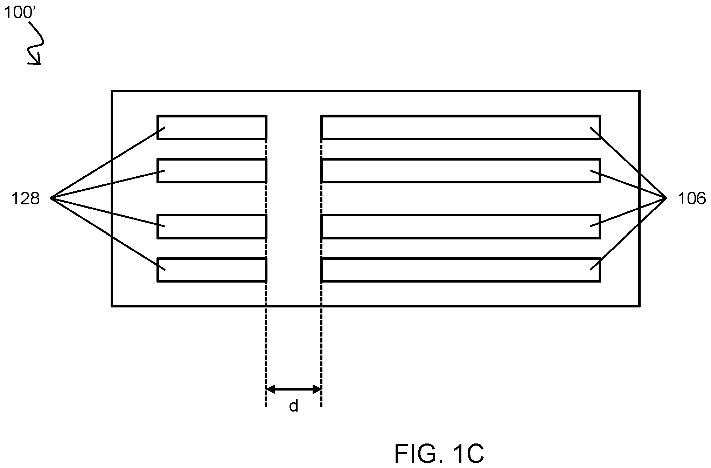

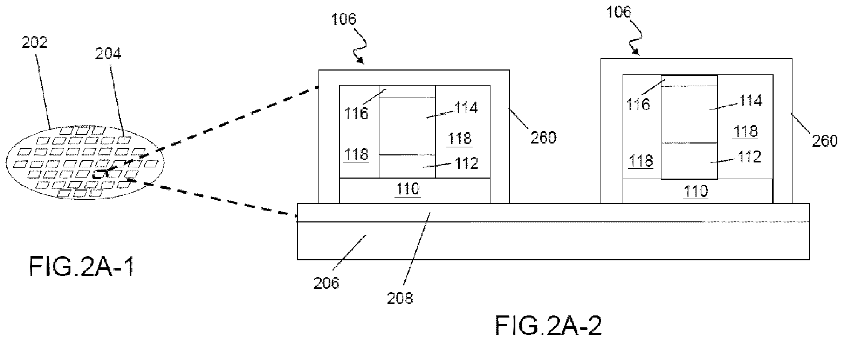

FIGS. 1A and 1B are a cross-sectional views of a schematic diagram of different embodiments of a semiconductor device 100. FIG. 1C is a top-down view of a schematic diagram of a semiconductor device 100' that is consistent with that of FIG. 1A , but with more laser structures and photodiodes. FIGS. 2A to 2J, 3A to 3F, and 4 are diagrams of exemplary methods involved in fabricating the semiconductor device 100 of FIGS. 1A, 1B and 1C.

FIG. 1A is a cross-sectional view of a schematic diagram of a semiconductor device 100. The semiconductor device comprises a silicon substrate 102 having a silica layer 104 thereon. One or more laser structures 106 are on the silica layer 104. The one or more laser structures 106 comprise layered III-V materials. There is a photodiode 128 on the silica layer 104. The photodiode 128 comprises layered III-V materials. The photodiode 128 is laterally and/or longitudinally displaced along the silica layer 104 from a closest laser structure of the one or more laser structures 106 by a maximum distance d, wherein d is less than 100 micrometres.

Turning to FIG. 1B, a semiconductor device 100 similar to that of FIG. 1A is shown, but with further features included. Common reference numerals denote common features. The semiconductor device 100 is a III-V silicon-on-insulator (SOI) coarse wavelength division modulation (CWDM) system. This example is a 4-channel CWDM system, with four laser structures 106 forming a laser array; however, any suitable number of channels can be used. This exemplary device includes the 4-channel laser array coupled to one or more modulators 126 (which can be silicon based, for example). The semiconductor device 100 also comprises one or more photodiodes 128, which can be in a receptor part of the device 100. In the example of FIG. 1B, only one photodiode is shown, but any suitable number could be included.

The device 100 comprises a silicon substrate 102 with a silica layer 104 thereon.

The aforementioned laser structures 106 and photodiode 128 are arranged on the silica layer 104. The laser structures 106 comprise layered III-V materials. The photodiode 128 also comprises layered III-V materials.

For each of the laser structures 106, the layered III-V materials can comprise an n-type doped InP layer 110 arranged on the silica layer 104. This can be a single n-type doped InP layer 110 that is shared between all of the laser structures 106 (as depicted in FIG. 1B). Alternatively, each of the laser structures 106 can have its own discrete n-type doped InP layer.

For each laser structure 106, a discrete quantum well layer 112 can then be arranged on the n-type doped InP layer 110. That is, each laser structure 106 can have its own quantum well layer 112.

The thickness of the quantum well layer 112 can be controlled to define the laser wavelength of the laser structure. The laser structures 106 of the laser array can have a different thicknesses for their respective quantum well layers 112, to provide different laser wavelengths in the laser array. In context, thickness is defined in the stacking direction of the III-V layers.

The quantum well layer 112 can be a single quantum well layer or a multiple quantum well (MQW) layer. The quantum well layer can comprise III-V semiconductor materials, such as an active section composed of AlₓGa_{y}In_{1-x-y}As or GaₓIn₁₋ₓAs_{1-y}P_{y} MQW based active region (with 0<=x, y<=1), for example.

A p-type doped InP layer 114 can then be arranged on the quantum well layer 112.

The p-type doped InP layer 114 can have substantially the same width, and be aligned with, the quantum well layer 112.

A p-type doped InGaAs layer 116 can then be arranged on the p-type doped InP layer 114.

The p-type doped InGaAs layer 116 can have substantially the same width, and be aligned with, the p-type doped InP layer 114.

The III-V materials are layered with a stacking direction that is a direction away from the silicon substrate 102.

Each of the laser structures 106 can further comprise a semi-insulating III-V material 118 extending at least partially along and at least partially surrounding the quantum well layer 112, the p-type doped InP layer 114 and the p-type doped InGaAs layer 116. The semi-insulating III-V material 118 can be arranged on the n-type doped InP layer 110.

The semi-insulating III-V material 118 can improve the heat dissipation of the laser array. In an example, the semi-insulating III-V material 118 can be semi-insulating InP.

The photodiode 128 can be InGaAs-based, and the layered III-V materials can comprise an n-type doped InP layer 160 on the silica layer 104. A p-type doped InGaAs layer 162 can then be arranged on the n-type doped InP layer 160. Then, a p-type doped InP layer 164 can be arranged on the p-type doped InGaAs layer 162. In some cases (not shown in the figure), on top of the p-type InP layer 164, a p-type InGaAs layer can be used to benefit from higher p-doping level for the p-type electrode

The photodiode 128 is laterally and/or longitudinally displaced along the silica layer 104 from a closest laser structure of the laser structures 106 by a maximum distance d. The distance d is less than 100 µm, and preferably less than 10 µm. The direction of this lateral and/or longitudinal displacement can be considered as a direction substantially orthogonal to the stacking direction of the layered III-V materials in the laser structure 106 and photodiode 128. That is, the photodiode 128 is displaced from the closest laser structure of the laser structures by the maximum distance d, wherein the distance d is in a plane or (or a plane parallel to) a plane in which the laser structures reside.

In FIGS. 1A and 1B, the photodiode is arranged alongside the laser structure(s), with the separation between the photodiode and the laser structure(s) being the distance d. In such a case, the photodiode might be considered as laterally displaced from the laser structures.

FIG. 1C is a view of an alternate arrangement of the laser structures 106 and a plurality of photodiodes 128, compared to that of FIGS. 1A and 1B, in a semiconductor device 100'. While FIG. 1A and FIG. 1B are cross-sections looking viewed along the laser structure(s) and photodiode, FIG. 1C is a top-down view of an alternative embodiment. In this alternate arrangement of FIG. 1C, the laser structures and photodiodes are arranged end-to-end, rather than alongside one another (as in FIGS. 1A and 1B), with this end-to-end separation being the distance d. In such a case, the photodiodes might be considered as longitudinally displaced from the laser structures. While a plurality of photodiodes are shown in FIG. 1C, the skilled person will appreciate that one or more photodiodes may be implemented. Likewise, while a plurality of laser structures are shown in FIG. 1C, the skilled person will appreciate that one or more laser structures may be implemented.

In some cases, the photodiode(s) and laser structure(s) may be separated both longitudinally and laterally, for example in a substantially diagonal direction, by the distance d.

For ease of presentation, hereinafter the arrangement of FIGS. 1A and 1B is referred to. However, the skilled person will readily understand that the teaching can also be applied to the arrangement of FIG. 1C.

Returning to FIG. 1B, photonic components are arranged in the silica layer 104. The photonic components can, for example, be made from silicon, SiN or SiGe.

The photonic components can comprise at least one modulator 126. The modulator 126 can be one or more modulators, and can be a PN junction modulator(s). This can be arranged at a position in the silica layer 104 that is laterally and/or longitudinally displaced away from the laser array. This lateral and/or longitudinal displacement can be in a direction that is substantially perpendicular to the stacking direction of the III-V materials in the laser structures 106.

The photonic components arranged in the silica layer 104 can further comprise one or more waveguides 122. These waveguides 122 can be disposed in a position aligned with and below the one or more laser structures 106, in the silica layer 104, and in a direction toward the silicon substrate 102. That is, each laser structure 106 can have a respective waveguide 122 positioned underneath it, in the silica layer 104.

The photonic components can also include a grating coupler 124, which can be silicon based. This grating coupler 124 can be laterally and/or longitudinally displaced away from the laser array. For example, this lateral and/or longitudinal displacement can be in a direction opposite to the modulator 126, with respect to the position of the laser array. In other words, the modulator 126 can be in the silica layer 104 on one side of the laser array, and the grating coupler 124 can be in the silica layer 104 on the opposing side of the laser array. Other positionings of these components can be also be realised in/on the silica layer 104.

The silicon substrate 102 with the silica layer 104 thereon, with the photonic components arranged in the silica layer 104, can be considered as a photonic SOI wafer 101. This can be a 300 mm wafer.

The laser structures 106 and photodiode 128 can be buried in an encasing layer 108 arranged on the silica layer 104. The encasing layer 108 can be another silica layer, for example.

A series of openings can be arranged in a first surface 150 of the encasing layer 108. The first surface 150 of the encasing layer 108 can be a surface of the encasing layer 108 that is opposite to a surface of the encasing layer 108 that is arranged on the silica layer 104.

One or more first openings 132 of the series of openings connect to through-holes in the encasing layer 108, wherein these through-holes connect the first openings 132 to each of the laser structures 106. A metallization contact 120 can be arranged in each of these through-holes to provide a contact for each of the laser structures 106.

A second opening 134 of the series of openings connects to a through-hole in the encasing layer 108, wherein this through-hole connects the second opening 134 to the n-type doped InP layer 110 of the laser structures. The n-type doped InP layer 110 can have an extended portion that extends laterally and/or longitudinally away from the rest of the laser array; it is this extended portion to which the through-hole connects. The direction of this lateral and/or longitudinal extension can be considered a direction orthogonal to the stacking direction of the layered III-V materials. A metallization contact 130 can be arranged in this through-hole to provide a contact to the n-type doped InP layer 110 of the laser structure. Whist only one such second opening 134 and through-hole is shown in FIG. 1B, in alternative arrangements, more than one such second opening 134, through-hole and metallization contact 130 could be included, or such a second opening 134, through-hole and metallization contact could be provided for each of the laser structures 106. Alternatively, in the case of discrete n-type doped InP layers for each laser structure, interconnects can be arranged between the n-type doped InP layers 110 of each of the laser structures 106 and the second opening 134 and through-hole.

One or more third openings 136 of the series of openings connect to through-holes in the encasing layer 108, wherein these through-holes connect the third openings 136 to the modulator 126. In the example of FIG. 1B, there are two of these third openings 136 and associated through-holes; however, any suitable number could be used for the number of modulators present. The through-holes can be at least partially filled with a metallization material 138.

One or more fourth openings 140 of the series of openings connect to through-holes in the encasing layer 108, wherein these through-holes connect the fourth openings 140 to the p-doped InP layer of the photodiode 128. In the example of FIG. 1B, there is one of these fourth openings 140 and associated through-holes; however, any suitable number could be used for the number of photodiodes present. A metallization contact 142 can be arranged in these through-holes to provide a contact for the p-type doped InP layer of the photodiode 128.

One or more fifth openings 144 of the series of openings connect to through-holes in the encasing layer 108, wherein these through-holes connect the fifth openings 144 to the n-type doped InP layer 160 of the photodiode 128. The n-type doped InP layer 160 of the photodiode can have an extended portion that extends laterally and/or longitudinally away from the rest of the photodiode; it is this extended portion to which the through-hole connects. The direction of this lateral and/or longitudinal extension can be considered a direction orthogonal to the stacking direction of the layered III-V materials. In the example of FIG. 1B, there is one of these fifth openings 144 and associated through-holes; however, any suitable number could be used for the number of photodiodes present. A metallization contact 146 can be arranged in these through-holes to provide a contact for the n-type doped InP layer of the photodiode 128.

Turning to FIGS. 2A to 2J, an exemplary method for fabricating the semiconductor devices 100 of FIGS. 1A to 1C is presented.

FIGS. 2A-1 and 2A-2 show a first silicon substrate 206 having a first silica layer 208 thereon. First devices are arranged on the first silica layer 208. The first devices comprise layered III-V materials, and in this example the first devices are the laser structures 106 as described with reference to FIGS. 1A to 1C. In the example of FIG. 2A-2, there are two of these laser structures 106; however, any suitable number could be present.

In more detail, FIG. 2A-1 shows a perspective view of a schematic diagram of a first InP on Si (InPOSi) wafer 202, with InP coupons 204 thereon. The first InPOSi wafer 202 can be a 300 mm wafer.

FIG. 2A-2 shows a cross-sectional view of a schematic diagram of an exemplary InP coupon of the InP coupons 204 on the first InPOSi wafer 202. In examples, the coupons 204 can have a size of 5 to 10 mm.

Each coupon 204 can comprise one or more laser structures 106. For clarity, only two laser structures 106 are shown. However, any suitable number could be used. A coupon can be considered as a defined region on the wafer in which heterostructures are formed.

Each coupon 204 can have a layered structure on the first silicon substrate 206. The first silicon substrate 206 can be considered as the silicon substrate layer of the first InPOSi wafer 202.

The first silicon substrate 206 has the first silica layer 208 thereon. Layered III-V materials are arranged on the first silica layer 208 to provide a laser structure 106 consistent with that described with reference to FIGS. 1A to 1C.

The layered III-V materials of the laser structures comprise the n-type doped InP layer 110 arranged on the first silica layer. The quantum well layer 112 is arranged on the n-type doped InP layer 110. Then, the p-type doped InP layer 114 is arranged on the quantum well layer 112. Then, the p-type doped InGaAs layer 116 is arranged on the p-type doped InP layer 114.

The quantum well layers 112 of different laser structures 106 can have different thickness for different emission wavelengths; for example, the rightmost laser structure in FIG. 2A-2 has a thicker quantum well layer 112 than that of the leftmost laser structure.

The quantum layer 112, the p-type doped InP layer 114 and the p-type doped InGaAs layer 116 can be surrounded by the semi-insulating III-V material 118 which is arranged on the n-type doped InP layer 110.

The laser structures 106 can be at least partially encapsulated in a resist layer 260. The resist layer 260 may be a TI 35E photoresist, for example. The resist layer 260 is configured to protect the layered III-V materials in a subsequent step when the first silica layer 208 is etched. The resist layer 260 can be arranged to cover the top surface of the layered III-V materials; the top surface being the top-most surface of the layered III-V materials in a direction away from the first silica layer 208. The resist layer 260 can also be arranged to cover the side surfaces of the layered III-V materials; the side surfaces being the surfaces that connect between the top surface and the first silica layer 208.

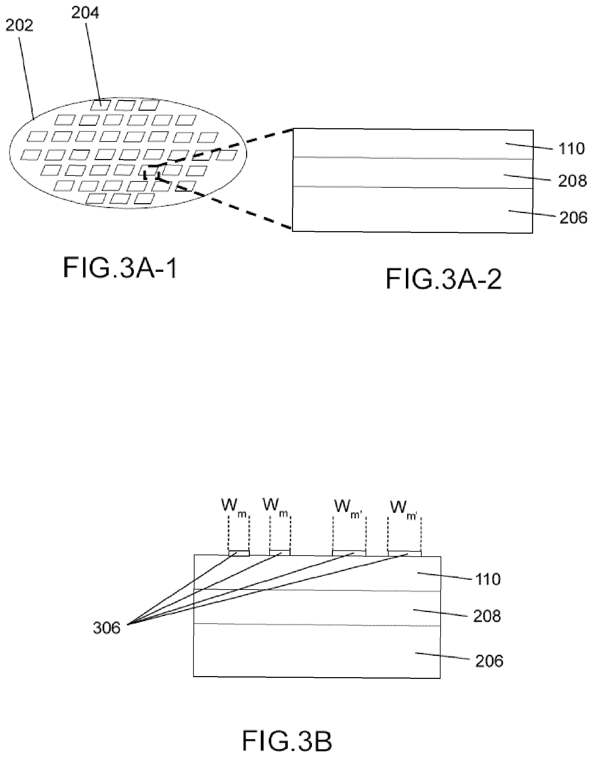

Exemplary steps for fabricating the structure of FIG. 2A-2 will later be described with reference to FIGS. 3A to 3F.

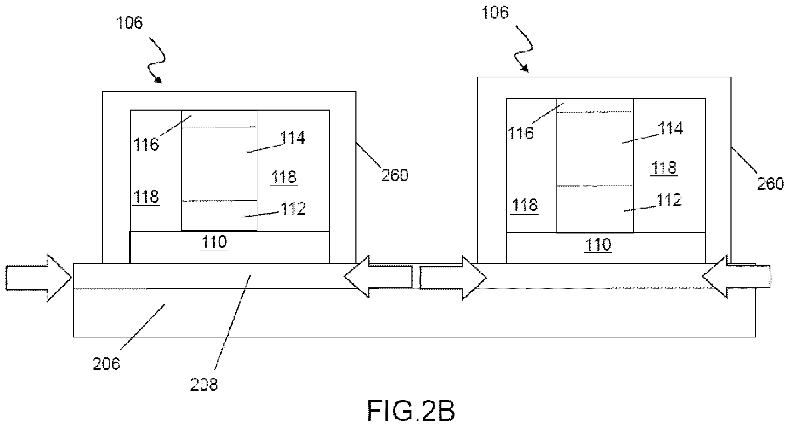

Turning to FIG. 2B, the first silica layer 208 is selectively etched to at least partially disconnect the laser structures 106 from the first silicon substrate 206. For example, the etching can be carried out in the direction depicted by the arrows. In an example, the etching can be carried out using HF.

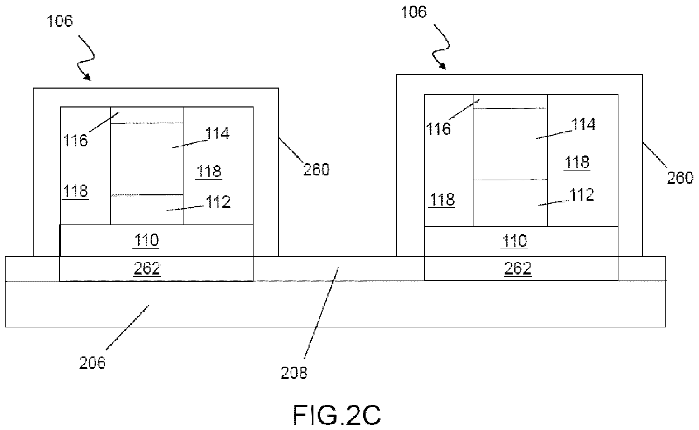

FIG. 2C shows the laser structures 106 at least partially disconnected from the first silicon substrate, wherein an etched region 262 is formed between the n-type doped InP layer 110 and the first silicon substrate 206. The etched region can be considered as a cavity.

In some examples, a tethering layer (not shown) can be arranged between the resist layer 260 and the III-V stack of the laser structure 106. This tethering layer can be silicon, for example. The tethering layer can be used to tether the laser structure 106 to the first silicon substrate 206 when the first silica layer 208 has been etched, before the laser structures 106 are removed by micro-transfer printing. In an example, the laser structures can be removed by breaking the tethers.

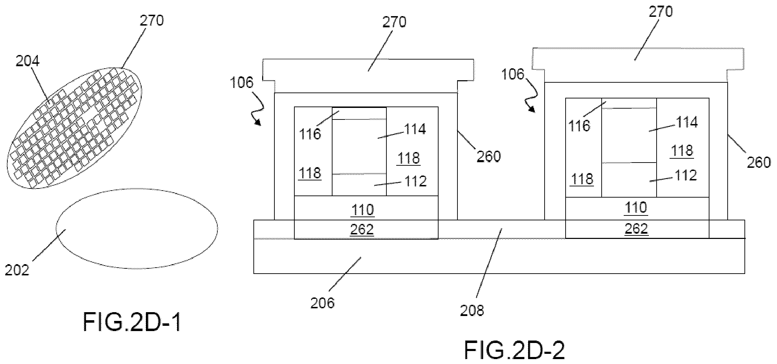

Turning to FIGS. 2D-1 and 2D-2, a first micro-transfer printing stamp 270 can be used to remove the laser structures 106 from the first silicon substrate 206.

This can be brought about by applying the first micro-transfer printing stamp 270 to the first InPOSi wafer 202 such that the stamp connects to the coupons 204. Then the first micro-transfer printing stamp 270 can be lifted away from the first InPOSi wafer 202, detaching the coupons 204 from the first InPOSi wafer 202, thereby releasing the laser structures 106 from the first silicon substrate 206. This is shown in the perspective view of the first micro-transfer printing stamp 270 and the first InPOSi wafer 202 in FIG. 2D-1.

FIG. 2D-2 shows a cross-sectional view before the laser structures 206 are released from the first silicon substrate. The first micro-transfer printing stamp can be affixed to the top surface of the resist layer on the laser structures 106.

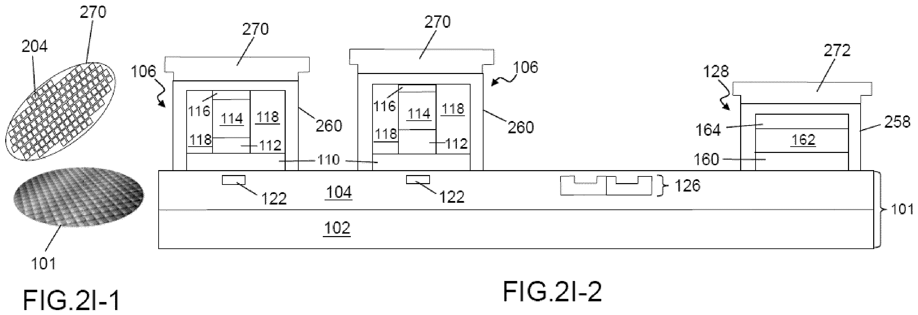

The coupons 204 comprising the laser structures 106 can then be transferred to a second substrate 102, as will be described with reference to FIG. 2I.

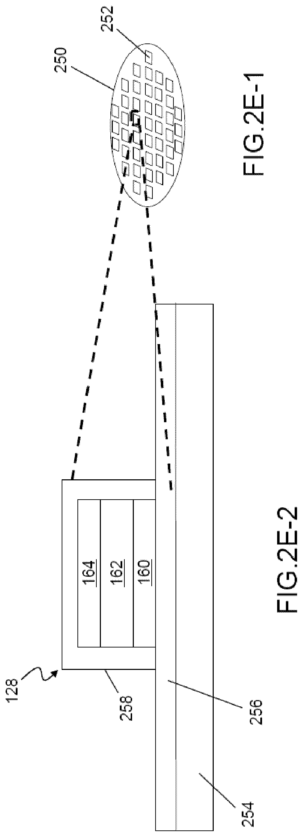

FIGS. 2E-1 and 2E-2 show a third silicon substrate 254 having a third silica layer 256 thereon. Second devices are arranged on the third silica layer 256. The second devices comprise layered III-V materials, and in this example the second devices are the photodiodes 128 as described with reference to FIGS. 1A to 1C. In the example of FIG. 2E-2, there is one of these second devices; however, any suitable number could be present.

In more detail, FIG. 2E-1 shows a perspective view of a schematic diagram of a second InPOSi wafer 250, with InP coupons 252 thereon. The second InPOSi wafer 250 can be a 300 mm wafer.

FIG. 2E-2 shows a cross-sectional view of a schematic diagram of an exemplary InP coupon of the InP coupons 252 on the InPOSi wafer 250. In examples, the coupons 252 can have a size of 5 to 10 mm.

Each coupon 252 can comprise one or more photodiodes 128. For clarity, only one photodiode 128 is shown. However, any suitable number could be used.

Each coupon 252 can have a layered structure on the third silicon substrate 254. The third silicon substrate 254 can be considered as the silicon substrate layer of the second InPOSi wafer 250.

The third silicon substrate 254 has the third silica layer 256 thereon. Layered III-V materials are arranged on the third silica layer 256 to provide a photodiode 128 consistent with that described with reference to FIGS. 1A to 1C.

The layered III-V materials of the photodiode comprise the n-type doped InP layer 160 arranged on the third silica layer 256. The p-type doped InGaAs layer 162 is arranged on the n-type doped InP layer 160. Then, the p-type doped InP layer 164 is arranged on the p-type doped InGaAs layer 162.

The photodiode 128 can be at least partially encapsulated in a resist layer 258. The resist layer 258 may be a TI 35E photoresist, for example. The resist layer 258 is configured to protect the layered III-V materials in a subsequent step when the third silica layer 256 is etched. The resist layer 258 can be arranged to cover the top surface of the layered III-V materials; the top surface being the surface top-most surface of the layered III-V materials in a direction away from the third silica layer 256. The resist layer 258 can also be arranged to cover the side surfaces of the layered III-V materials; the side surfaces being the surfaces that connect between the top surface and the third silica layer 256.

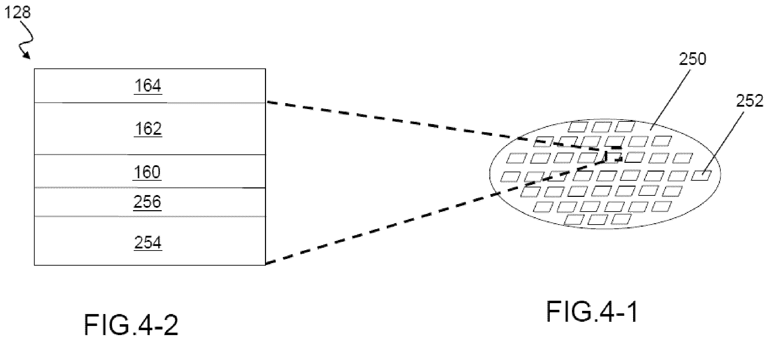

Exemplary steps for fabricating the structure of FIG. 2E-2 will later be described with reference to FIG. 4.

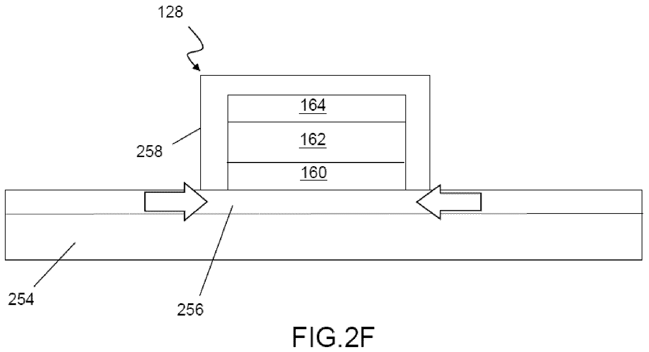

Turning to FIG. 2F, the third silica layer 256 is selectively etched to at least partially disconnect the photodiode 128 from the third silicon substrate 254. For example, the etching can be carried out in the direction depicted by the arrows. In an example, the etching can be carried out using HF.

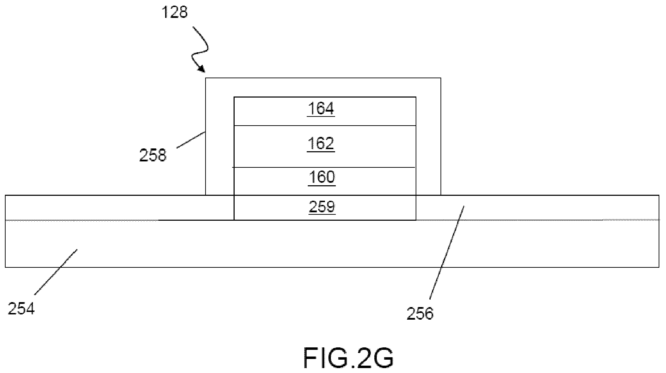

FIG. 2G shows the photodiode 128 at least partially disconnected from the third silicon substrate 254, wherein an etched region 259 is formed between the n-type doped InP layer 160 and the third silicon substrate 254. The etched region 259 can be considered as a cavity.

In some examples, a tethering layer (not shown) can be arranged between the resist layer 258 and the III-V stack of the photodiode 128. This tethering layer can be silicon, for example. The tethering layer can be used to tether the photodiode 128 to the third silicon substrate 254 when the third silica layer 256 has been etched, before the photodiodes 128 are removed by micro-transfer printing. In an example, the photodiodes can be removed by breaking the tethers.

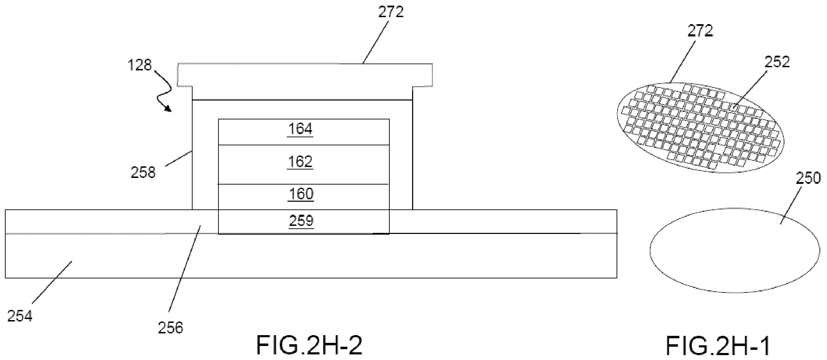

Turning to FIGS. 2H-1 and 2H-2, a second micro-transfer printing stamp 272 can be used to remove the photodiodes 128 from the third silicon substrate 254.

This can be brought about by applying the second micro-transfer printing stamp 272 to the second InPOSi wafer 250 such that the stamp connects to the coupons 252. Then the second micro-transfer printing stamp 272 can be lifted away from the second InPOSi wafer 250, detaching the coupons 252 from the second InPOSi wafer 250, thereby releasing the photodiodes 128 from the third silicon substrate 254. This is shown in the perspective view of the second micro-transfer printing stamp 272 and the second InPOSi wafer 250 in FIG. 2H-1.

FIG. 2H-2 shows a cross-sectional view before the photodiode 128 is released from the third silicon substrate 254. The second micro-transfer printing stamp 272 can be affixed to the top surface of the resist layer 258 on the photodiode 128.

The coupons 252 comprising the photodiodes 128 can then be transferred to the second substrate 102, as will be described with reference to FIG. 2I.

Turning to FIGS. 2I-1 and 2I-2, the second silicon substrate 102 is provided. The second silicon substrate 102 has a second silica layer 104 thereon. One or more photonic components are arranged in the second silica layer 104.

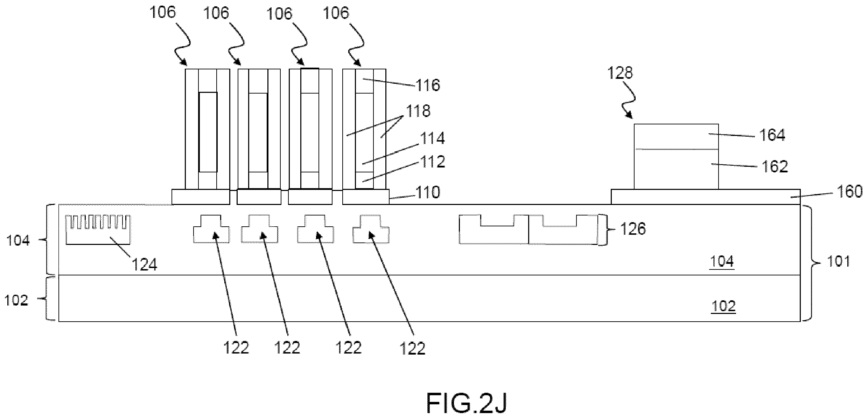

The second silicon substrate 102 can be considered as the silicon substrate 102 of FIGS. 1A and 1B. The second silica layer 104 can be considered as the silica layer 104 of FIGS. 1A and 1B. The second silicon substrate 102 and second silica layer thereon can be considered as the photonic SOI wafer 101 of FIGS. 1A and 1B. The photonic components arranged in the second silica layer 104 can comprise the waveguides 122, grating coupler 124 (shown on FIG. 2J), and modulator 126 as described with reference to FIG. 1B; the detail is not repeated here, for brevity.

The laser structures 106 are deposited onto the second silica layer 104, from the first micro-transfer printing stamp 270.

The photodiodes 128 are also deposited onto the second silica layer 104, from the second micro-transfer printing stamp 272.

The speed and angle can be controlled to operate the bonding while detaching the coupons from the stamp. The bonding can a hydrophilic direct bonding process between SiO₂/SiO₂ surfaces. In an alternative, a polymer layer (such as BCB) can be used between the SiO2/SiO₂ surfaces for the bonding.

The photodiode 128 and laser structures 106 can be deposited on the photonic SOI wafer 101 such that, for a CWDM system such as that of FIG. 1B, the photodiode is laterally and/or longitudinally displaced along the second silica layer 104 from a closest laser structure of the laser array by a maximum distance d, wherein d is less than 100 µm, and preferably less than 10 µm.

Figure 2I-1 shows a perspective view of the first micro-transfer printing stamp 270 with the coupons 204 thereon that comprise the laser structures 106 being brought into connection with the photonic SOI wafer 101. In a similar manner, the second micro-transfer printing stamp 272 with the coupons 252 thereon that comprise the photodiodes 128 is brought into connection with the photonic SOI wafer 101 (this is not shown in the figure). In this way, the first devices (e.g., the laser structures 106) can be deposited onto the photonic SOI wafer 101, and the second devices (e.g., the photodiodes 128) can be deposited onto the same photonic SOI wafer 101.

This two-step micro-transfer printing process can fabricate one or more devices on the photonic SOI wafer that are multi-channel CWDM systems with the laser array and receptor part having at least one photodiode, as shown in FIG. 1B.

FIG. 2J shows an example of such a device in which four laser structures 106 are deposited on the photonic SOI wafer 101, with one photodiode 128. This can be considered as a 4-channel CWDM system with an InGaAs-based photodiode. Whilst this example uses four laser structures 106 in the laser array and one photodiode 128, any suitable number of photodiodes and laser structures can be fabricated into the device.

Then, the laser structures 106 can be buried in the encasing layer 108, as described with reference to FIG. 1B.

Openings 132, 134, 136, 140, 144 and through-holes can be formed in the encasing layer 108, as described with reference to FIG. 1B, and metallization layers 120, 130, 138, 142, 146 can be deposited, as described with reference to FIG. 1B.

In some cases, the metallization can be carried out in a two-step process. The first step is to aid specific metal deposition for n and p type electrodes (the optimum can different for each electrode), and the second is to thicken the metal, which is collectively done for n and p type. The first-step metallization can be done prior to integration on the photonic SOI wafer 101; it can be done when the laser structures 106 and photodiodes 128 are respectively still on the first silicon substrate 206 and third silicon substrate 254 (InPoSi wafers).

Altogether, this methodology is highly versatile and allows III-V heterostructures grown on an InPOSi wafer to be integrated onto any kind of SOI wafer, from photonic structures to a broader range of structures grown on InPOSi.

In the aforementioned methodology, the laser array is transferred to the SOI photonic 101 wafer using a first step in the micro-transfer printing approach; the photodiode is also transferred to the SOI photonic 101 wafer using a second step in the micro-transfer printing approach. This approach allows for the dense integration of III-V coupons coming from different epitaxies on different wafers, and in this way the photodiode(s) can be laterally and/or longitudinally displaced along the silica layer from a closest laser structure of the one or more laser structures by a maximum distance d, wherein d is less than 100 micrometres. Since the epitaxy of the III-V devices, which requires >600°C temperature elevation, is done prior to the transfers to the SOI photonic wafer 101, there is a low thermal budget on the SOI photonic wafer 101 containing Si photonics functions thereby avoiding any damage to the SOI photonic wafer 101 and the components therein as the epitaxy is not performed on the SOI photonic wafer 101.

Then, the silica layers of the first InPOSi wafer on which the laser structures 106 are grown and the second InPOSi wafer on which the photodiodes are grown act as release layers. These are selectively etched. Silica is advantageous over other materials (such as AllnAs, as used in other micro-transfer printing approaches) because there is a much higher selectivity of silica/III-V than for AlInAs/III-V. Therefore, this improves the feasibility and the reproducibility of this approach. Also, the selective etching of silica can be as fast as several minutes when using a e.g. an HF etching solution, with an inhibited risk of III-V etching.

The two-step micro-transfer printing process is beneficial in that it allows for particularly high resolution to be achieved in the overall device (i.e. the CWDM system with the photodiode), in that the photodiode 128 can be placed less than 100 µm from the laser array, and preferably less than 10 µm from the laser array.

Furthermore, the process is fully 300 mm compatible as the laser structures and photodiodes can be grown on 300 mm InPOSi wafers, and the photonic SOI wafer can also be a 300 mm wafer.

Turning to FIGS. 3A to 3F, an exemplary method of fabricating the first silicon substrate having the first silica layer thereon, and the layered III-V materials of the laser structure(s) on the first silica layer, of FIG. 2A-1 and 2A-2, is presented.

The process begins with the first InPOSi wafer 202 with InP coupons 204 thereon.

FIG. 3A-1 shows a perspective view of a schematic diagram of the first InPOSi wafer 202, with InP coupons 204 thereon.

FIG. 3A-2 shows a cross-sectional view of a schematic diagram of an exemplary InP coupon of the InP coupons 204 on the first InPOSi wafer 202.

The first InPOSi wafer 202 of FIG. 3A can be considered the same InPOSi wafer 202 of FIG. 2A, and the InP coupons 204 of FIG. 3A can be considered the same InP coupons 204 of FIG. 2A, albeit before the additional III-V layers of the laser structure(s) 106 are grown.

Looking to FIG. 3A-2, the first InPOSi wafer 202 is structured as the first silicon substrate 206, with the first silica layer thereon 208, and the n-type doped InP layer 110 on the silica layer 208, in the same manner as that of FIG. 2A.

Selective area growth (SAG) can then be used to grow the multi-wavelength laser array on the first InPOSi wafer 202. The SAG can be carried out, for example, using metalorganic vapour-phase epitaxy (MOVPE) systems with selective mask patterns (typically made from silica) that are defined prior to growth, to locally enhance the growth rate of the grown structure. SAG can be used for growth of the quantum well layer to obtain a thickness variation hence photoluminescence (PL) variation between different regions on the same wafer, by varying locally the width of the mask (Wm). Mask widths can change the gas environment during epitaxial growth and lead to the tuning of the growth rate, especially in the short vicinity of such masks. Consequently the thicknesses of the layers can be changed accordingly, meaning that the emission wavelength can be tuned by the mask width.

In an example, from one growth step, a 240 nm wide PL range can be obtained due to the growth rate enhancement achieved by SAG.

In an example, the SAG process can be adapted to grow the multi-channel laser array for the CWDM system. The process flow can begin with the deposition of dielectric masks 306 on the first InPOSi wafer 202.

FIG. 3B shows a cross-sectional view of a schematic diagram of the InP coupon of FIG. 3A-2, with the mask(s) 306 added. The mask(s) have two different widths (Wₘ and W_{m'}).

Turning to FIGS. 3C-1 and 3C-2, growth of the quantum well layer 112 is performed.

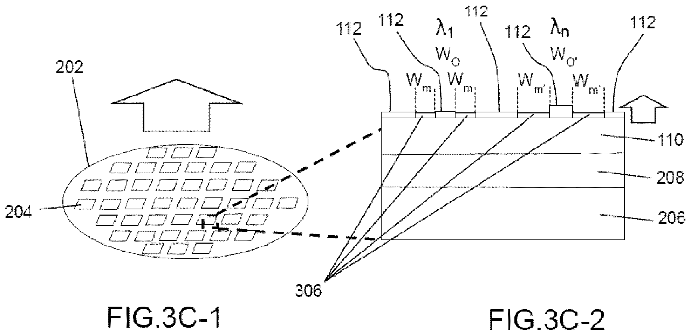

FIG. 3C-1 shows a perspective view of a schematic diagram of the first InPOSi wafer 202, with the arrow indicating the direction of growth of the quantum well layer 112.

FIG. 3C-2 shows a cross-sectional view of a schematic diagram of an exemplary InP coupon of the InP coupons 204 on the first InPOSi wafer 202, with the mask 306 applied, and growth of the quantum well layer 112 in the direction indicated by the arrow. The growth happens in a direction opposite to the direction of the substrate from the n-type doped InP layer 110.

The mask 306 allows for the growth to be confined to the openings in the mask. The mask 306 can be used to define different opening sizes (Wₒ and W_{o'}) for thickness variation in the quantum well layer 112, for different laser wavelengths (λ₁ and λₙ).

The space or opening (Wₒ) between the pairs of dielectric stripes of the mask 306 can be set to be between, for example, 20 and 30 µm. The width of the masks (Wₘ) is set for each laser array in order to obtain the desired wavelengths (λ₁...λₙ). The quantum well based active region of each laser structure can be selectively grown onto the large size InPOSi wafer.

Turning to FIGS. 3D-1 and 3D-2, the mask 306 can be etched and the p-type cladding (the p-type doped InP layer 114) can be grown. Then, the p-type doped InGaAs layer 116 can be grown on the p-type doped InP layer 114.

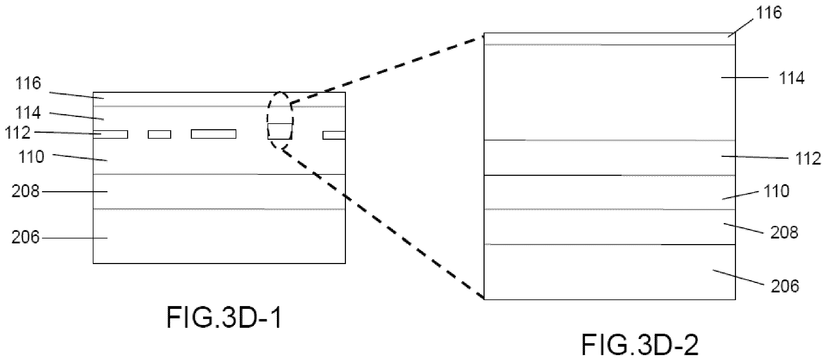

FIG. 3D-1 shows cross-sectional view of a schematic diagram of the exemplary InP coupon with the p-type doped InP layer 114 grown on the quantum well layer 112, and the p-type doped InGaAs layer 116 grown on the p-type doped InP layer 114.

The quantum well layers 112 of different laser structures can have different thickness for different emission wavelengths.

FIG. 3D-2 shows an enhanced view of FIG. 3D-1 for a single laser structure of the InP coupon.

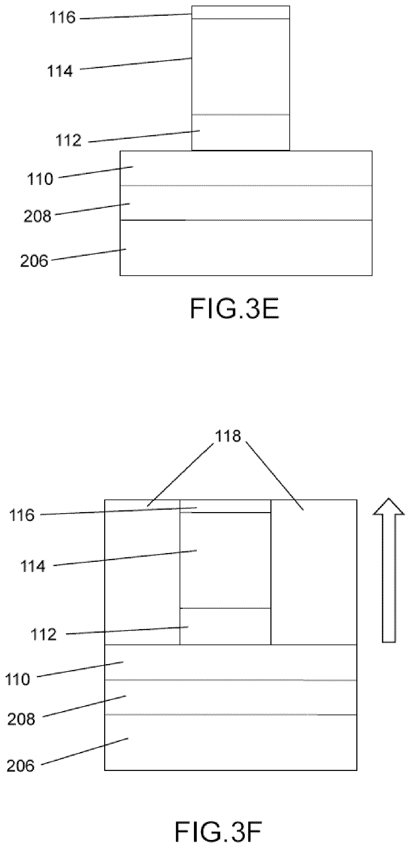

In order to improve the heat dissipation of the III-V laser arrays, each one can be etched and the semi-insulating InP material 118 can be grown, as discussed with reference to FIGS. 1A and 1B. This can be by a semi-insulating buried heterostructure (SIBH) technology. This is depicted in FIGS. 3E and 3F.

Through this exemplary process of FIGS 3A to 3F, the structure of FIG. 2A-1 and FIG. 2A-2 can be achieved for the process of FIGS. 2A to 2F.

Turning to FIGS. 4-1 and 4-2, an exemplary fabrication of the layered III-V materials of the photodiode 128 on the third silicon substrate 254 having the third silica layer 256 thereon, and , of FIG. 2E-1 and 2E-2, is presented.

FIG. 4-1 shows the second InPOSi wafer 250 with the coupons 252 thereon, wherein the coupons comprise one or more photodiodes 128. FIG. 4-2 shows a cross-sectional view of a portion of one of these coupons 128, pertaining to one photodiode 128.

The second InPOSi wafer 250 is formed from the third silicon substrate 254 having the third silica layer 256 thereon, and the n-type doped InP layer 160 can be grown on the third silica layer 256. The p-type doped InGaAs layer 162 can then be grown on the n-type doped InP layer 160. Then, the p-type doped InP layer 164 can be grown on the p-type doped InGaAs layer 162. This can form an InGaAs-based photodiode structure. This can be carried out to form one or more photodiodes as each of the coupons 252. An etching step can be used to define separate photodiodes and the sizes of these.

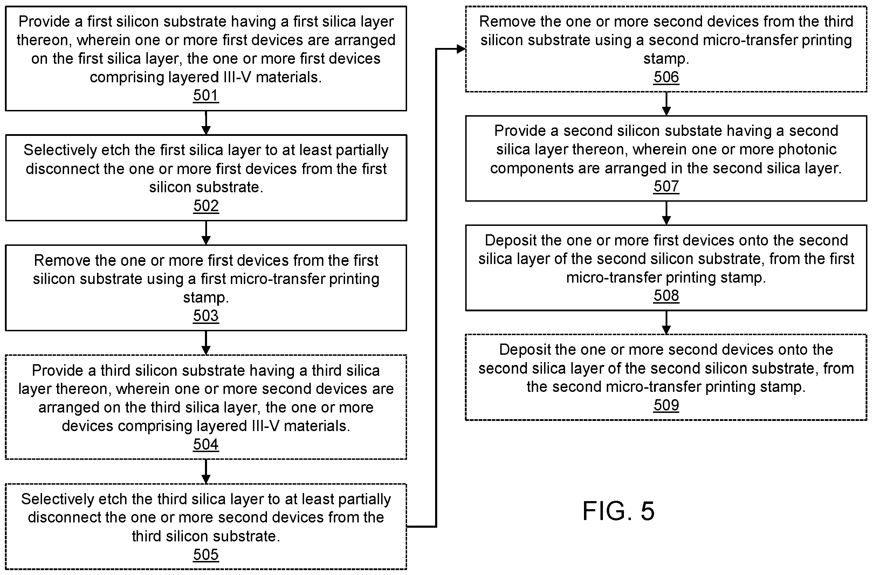

FIG. 5 is a flow chart of a semiconductor device fabrication method that corresponds to the semiconductor device fabrication methods described with reference to FIGS. 2A to 2J.

At step 501, a first silicon substrate is provided, having a first silica layer thereon, wherein one or more first devices are arranged on the first silica layer, the one or more first devices comprising layered III-V materials.

At step 502, the first silica layer is selectively etched to at least partially disconnect the one or more first devices from the first silicon substrate.

At step 503, the one or more first devices are removed from the first silicon substrate using a first micro-transfer printing stamp.

At step 504, a third silicon substrate can be provided, having a third silica layer thereon, wherein one or more second devices are arranged on the third silica layer, the one or more devices comprising layered III-V materials.

At step 505, the third silica layer can be selectively etched to at least partially disconnect the one or more second devices from the third silicon substrate.

At step 506, the one or more second devices can be removed from the third silicon substrate using a second micro-transfer printing stamp.

At step 507, a second silicon substate is provided having a second silica layer thereon, wherein one or more photonic components are arranged in the second silica layer.

At step 508, the one or more first devices are deposited onto the second silica layer of the second silicon substrate, from the first micro-transfer printing stamp.

At step 509, the one or more second devices can be deposited onto the second silica layer of the second silicon substrate, from the second micro-transfer printing stamp.

Although the foregoing description has been set out with reference to particular examples, it is to be understood that these examples are merely illustrative of the principles and applications of the present disclosure. It is therefore to be understood that numerous modifications can be made to the illustrative examples and that other arrangements can be devised without departing from the spirit and scope of the disclosure as determined based upon the claims and any equivalents thereof.

## Claims

1. A semiconductor device comprising:
a silicon substrate (102) having a silica layer (104) thereon;
one or more laser structures (106) on the silica layer, wherein the one or more laser structures comprise layered III-V materials (110, 112, 114, 116, 118); and
a photodiode (128) on the silica layer, wherein the photodiode comprises layered III-V materials (160, 162, 164);
wherein the photodiode is laterally and/or longitudinally displaced along the silica layer from a closest laser structure of the one or more laser structures by a maximum distance d, wherein d is less than 100 micrometers.

2. The semiconductor device of claim 1, wherein the distance d is less than 10 micrometers.

3. The semiconductor device of any preceding claim, wherein the layered III-V materials of the one or more laser structures comprise:
an n-type doped InP layer (110) on the silica layer;
a quantum well layer (112) on the n-type doped InP layer;
a p-type doped InP layer (114) on the quantum well layer; and
a p-type doped InGaAs layer (116) on the p-type doped InP layer.

4. The semiconductor device of claim 3, wherein the one or more laser structures further comprise:
a semi-insulating InP layer (118) arranged on the n-type doped InP layer and extending at least partially along and at least partially surrounding the quantum well layer, the p-type doped InP layer and the p-type doped InGaAs layer.

5. The semiconductor device of any preceding claim, wherein the photodiode is an InGaAs-based photodiode.

6. The semiconductor device of claim 5, wherein the layered III-V materials of the photodiode comprise:
an n-type doped InP layer (160) on the silica layer;
a p-type doped InGaAs layer (162) on the n-type doped InP layer; and
a p-type doped InP layer (164) on the p-type doped InGaAs layer.

7. The semiconductor device of any preceding claim, wherein one or more photonic components are comprised within the silica layer.

8. The semiconductor device of claim 7, wherein the one or more photonic components comprise a PN junction modulator (126).

9. The semiconductor device of any preceding claim, wherein the photodiode and one or more laser structures are buried in an encasing layer (108) arranged on the silica layer.

10. The semiconductor device of claim 9, further comprising first through-holes (134,144) in the encasing layer, the first through-holes connecting a surface (150) of the encasing layer away from the silica layer to bottom layers of the photodiode and one or more laser structures, the bottom layers being layers of the III-V materials abutting the silica layer; and
second through-holes (132, 140) in the encasing layer, the second through-holes connecting the surface of the encasing layer to top layers of the photodiode and one or more laser structures, the top layers being layers of the III-V materials away from the silica layer;
wherein metallization layers (120, 130, 142, 146) are arranged in the first through-holes and the second through-holes as electric contacts of the photodiode and one or more laser structures.

11. The semiconductor device of any preceding claim, wherein the one or more laser structures are a plurality of laser structures configured as a coarse wavelength division multiplexer.

12. A semiconductor device fabrication method, the method comprising:
providing (501) a first silicon substrate having a first silica layer thereon, wherein one or more devices are arranged on the first silica layer, the one or more devices comprising layered III-V materials;
selectively etching (502) the first silica layer to at least partially disconnect the one or more devices from the first silicon substrate;
removing (503) the one or more devices from the first silicon substrate using a micro-transfer printing stamp;
providing (507) a second silicon substate having a second silica layer thereon, wherein one or more photonic components are arranged in the second silica layer;
depositing (508) the one or more devices onto the second silica layer of the second silicon substrate, from the micro-transfer printing stamp.

13. The semiconductor device fabrication method of claim 12, wherein the one or more devices are a laser structure or a photodiode;
wherein the layered III-V materials of the laser structure comprise:
an n-type doped InP layer on the silica layer;
a quantum well layer on the n-type doped InP layer;
a p-type doped InP layer on the quantum well layer; and
a p-type doped InGaAs layer on the p-type doped InP layer;
and wherein the layered III-V materials of the photodiode comprise:
an n-type doped InP layer on the silica layer;
a p-type doped InGaAs layer on the n-type doped InP layer; and
a p-type doped InP layer on the p-type doped InGaAs layer.

14. The method of claim 12 or claim 13, further comprising:
at least partially encapsulating the one or more devices with a resist layer before selectively etching the first silica layer to at least partially disconnect the one or more devices from the first silicon substrate.

15. The semiconductor device fabrication method of any one of claims 12 to 14, wherein the one or more devices are one or more first devices, and the method further comprises:
providing (504) a third silicon substrate having a third silica layer thereon, wherein one or more second devices are arranged on the third silica layer, the one or more second devices comprising layered III-V materials that are a different type of device to the one or more first devices;
selectively (505) etching the third silica layer to at least partially disconnect the one or more second devices from the third silicon substrate;
removing (506) the one or more second devices from the third silicon substrate using a second micro-transfer printing stamp;
depositing (509) the one or more second devices onto the second silica layer of the second silicon substrate, from the second micro-transfer printing stamp.
